# FASCICULE DE BREVET EUROPEEN

(11) **EP 3 646 383 B1**
(45) Date de publication et mention de la délivrance du brevet: **17.08.2022**
(21) Numéro de dépôt: 18749841.5
(22) Date de dépôt: 28.06.2018
(51) Int. Cl.: H01L 27/15, H01L 27/144, H01L 33/00, H01L 33/08, H01L 25/075, H01L 33/18, H01L 33/24, H01L 33/20, H01L 31/0352

(54) **DISPOSITIF OPTOELECTRONIQUE COMPORTANT DES STRUCTURES SEMICONDUCTRICES TRIDIMENSIONNELLES EN CONFIGURATION AXIALE**
OPTOELEKTRONISCHE VORRICHTUNG MIT DREIDIMENSIONALEN HALBLEITERSTRUKTUREN IN AXIALER ANORDNUNG
OPTOELECTRONIC DEVICE COMPRISING THREE-DIMENSIONAL SEMICONDUCTOR STRUCTURES IN AN AXIAL CONFIGURATION

(30) Priorité: 30.06.2017 FR 1756161
(43) Date de publication de la demande: 06.05.2020
(73) Titulaire: Aledia, 38130 Echirolles (FR)
(72) Inventeur: POURQUIER, Eric, 38000 Grenoble (FR)
(74) Mandataire: Cabinet Beaumont
(86) Numéro de dépôt international: PCT/FR2018/051604
(87) Numéro de publication internationale: WO 2019/002786

(56) Documents cités:
- EP-A1- 2 357 676
- WO-A1-2011/048318
- WO-A1-2013/068125
- US-A1- 2014 209 859

## Description

### Domaine

La présente invention concerne de façon générale les dispositifs optoélectroniques comprenant des éléments semiconducteurs tridimensionnels de type nanofils ou microfils, et leur procédé de fabrication, et plus particulièrement les dispositifs optoélectroniques adaptés à afficher des images, notamment un écran d'affichage ou un dispositif de projection d'images.

### Exposé de l'art antérieur

Un pixel d'une image correspond à l'élément unitaire de l'image affichée ou captée par le dispositif optoélectronique. Pour l'affichage d'images couleur, le dispositif optoélectronique comprend en général, pour l'affichage de chaque pixel de l'image, au moins trois composants, également appelés sous-pixels d'affichage, qui émettent chacun un rayonnement lumineux sensiblement dans une seule couleur (par exemple, le rouge, le vert et le bleu). La superposition des rayonnements émis par ces trois sous-pixels d'affichage fournit à l'observateur la sensation colorée correspondant au pixel de l'image affichée. Dans ce cas, on appelle pixel d'affichage du dispositif optoélectronique l'ensemble formé par les trois sous-pixels d'affichage utilisés pour l'affichage d'un pixel d'une image.

Il existe des dispositifs optoélectroniques comportant des éléments semiconducteurs tridimensionnels de type nanofils ou microfils permettant la réalisation de diodes électroluminescentes dites tridimensionnelles. Une diode électroluminescente comprend une zone active qui est la région de la diode électroluminescente depuis laquelle est émise la majorité du rayonnement électromagnétique fourni par la diode électroluminescente. Une diode électroluminescente tridimensionnelle peut être réalisée dans une configuration dite radiale, également appelée coeur/coquille, dans laquelle la zone active est formée à la périphérie de l'élément semiconducteur tridimensionnel. Elle peut également être réalisée dans une configuration dite axiale, dans laquelle la zone active ne recouvre pas la périphérie de l'élément semiconducteur tridimensionnel mais s'étend essentiellement suivant un axe longitudinal de croissance épitaxiale.

Les diodes électroluminescentes tridimensionnelles en configuration axiale ont une surface d'émission inférieure à celle des diodes électroluminescentes en configuration radiale, mais présentent l'avantage d'être réalisées en un matériau semiconducteur de meilleure qualité cristalline offrant ainsi un rendement quantique interne supérieur, du fait notamment d'une meilleure relaxation des contraintes aux interfaces entre les couches semiconductrices. Dans le cas de puits quantiques réalisés en InGaN, les diodes électroluminescentes tridimensionnelles en configuration axiale permettent ainsi d'incorporer davantage d'indium pour émettre par exemple dans le rouge ou le vert.

Il existe un besoin de réaliser un dispositif optoélectronique dont les pixels d'affichage ont une dimension latérale réduite, notamment inférieure à 5 µm. Toutefois, la réalisation d'un tel dispositif optoélectronique avec des diodes électroluminescentes tridimensionnelles en configuration axiale peut être difficile. En outre, il serait souhaitable que le procédé de fabrication du dispositif optoélectronique comprenne le plus possible d'étapes communes avec un procédé de fabrication d'un dispositif optoélectronique comprenant des diodes électroluminescentes planaires dans lesquelles les zones actives des diodes électroluminescentes sont formées sur des couches planes.

Les documents US 2014/209859 et WO 2011/048318 décrivent des dispositifs optoélectroniques à diodes électroluminescentes.

### Résumé

La présente invention divulgue selon la revendication 1 un procédé de fabrication d'un dispositif optoélectronique. D'autres modes de réalisation sont décrits dans les revendications dépendantes.

La présente invention prévoit un procédé de fabrication d' un dispositif optoélectronique comprenant un premier circuit optoélectronique fixé à un deuxième circuit électronique, le deuxième circuit électronique comprenant des plots conducteurs électriquement, le premier circuit optoélectronique comprenant des pixels et comportant, pour chaque pixel :
une première couche conductrice électriquement ;
au moins des premiers et deuxièmes éléments semiconducteurs tridimensionnels s'étendant perpendiculairement à la première couche conductrice électriquement et au contact de la première couche conductrice électriquement et ayant la même hauteur mesurée perpendiculairement à la première couche conductrice électriquement ;
des premières zones actives reposant sur les extrémités des premiers éléments semiconducteurs tridimensionnels opposées à la première couche conductrice électriquement et adaptées à émettre ou capter un premier rayonnement électromagnétique à une première longueur d'onde ;
des deuxièmes zones actives reposant sur les extrémités des deuxièmes éléments semiconducteurs tridimensionnels opposées à la première couche conductrice électriquement et adaptées à émettre ou capter un deuxième rayonnement électromagnétique à une deuxième longueur d'onde différente de la première longueur d'onde ; et
des deuxième, troisième et quatrième couches conductrices électriquement reliées électriquement aux plots conducteurs électriquement, la deuxième couche conductrice électriquement étant reliée aux premières zones actives, la troisième couche conductrice électriquement étant reliée aux deuxièmes zones actives et la quatrième couche conductrice électriquement étant reliée à la première couche conductrice électriquement.

Selon un mode de réalisation, le diamètre de chaque premier élément semiconducteur au contact avec la première couche conductrice électriquement est inférieur au diamètre de chaque deuxième élément semiconducteur au contact avec la première couche conductrice électriquement.

Selon un mode de réalisation, les premiers éléments semiconducteurs tridimensionnels sont régulièrement répartis selon un premier pas moyen et les deuxièmes éléments semiconducteurs tridimensionnels sont régulièrement répartis selon un deuxième pas moyen différent du premier pas moyen.

Selon un mode de réalisation, le premier circuit optoélectronique comprend, en outre, pour chaque pixel :
au moins des troisièmes éléments semiconducteurs tridimensionnels s'étendant perpendiculairement à la première couche conductrice électriquement et au contact de la première couche conductrice électriquement, les premiers, deuxièmes et troisièmes éléments semiconducteurs tridimensionnels ayant la même hauteur mesurée perpendiculairement à la première couche conductrice électriquement ;
des troisièmes zones actives reposant sur les extrémités des troisièmes éléments semiconducteurs tridimensionnels opposées à la première couche conductrice électriquement et adaptées à émettre ou capter un rayonnement électromagnétique à une troisième longueur d'onde différente des première et deuxième longueurs d'onde ; et
une cinquième couche conductrice électriquement reliée électriquement à l'un des plots conducteurs électriquement et reliée aux troisièmes zones actives.

Selon un mode de réalisation, le diamètre de chaque deuxième élément semiconducteur au contact avec la première couche conductrice électriquement est inférieur au diamètre de chaque troisième élément semiconducteur au contact avec la première couche conductrice électriquement.

Selon un mode de réalisation, les troisièmes éléments semiconducteurs tridimensionnels sont régulièrement répartis selon un troisième pas moyen différent du premier pas moyen et du deuxième pas moyen.

Selon un mode de réalisation, les premières et deuxièmes zones actives comprennent un puits quantique unique ou des puits quantiques multiples.

Selon un mode de réalisation, les premiers et deuxièmes éléments semiconducteurs tridimensionnels sont majoritairement en un matériau semiconducteur choisi dans le groupe comprenant les composés III-V, les composés II-VI ou les semiconducteurs ou composés du groupe IV.

Selon un mode de réalisation, les premiers et deuxièmes éléments semiconducteurs tridimensionnels sont de forme filaire, conique ou tronconique.

Selon un mode de réalisation, la dimension maximale de chaque pixel mesurée parallèlement à la première couche conductrice électriquement est inférieure à 5 µm.

Un mode de réalisation prévoit également un procédé de fabrication du dispositif optoélectronique tel que défini précédemment, comprenant les étapes successives suivantes :
a) former le premier circuit optoélectronique ; et
b) fixer le premier circuit optoélectronique à un deuxième circuit électronique en reliant électriquement les deuxième, troisième et quatrième couches conductrices électriquement aux plots conducteurs électriquement.

Selon un mode de réalisation, l'étape a) comprend les étapes successives suivantes :
c) former simultanément sur un support les premiers et deuxièmes éléments semiconducteurs tridimensionnels ;
d) former simultanément les premières zones actives sur les extrémités des premiers éléments semiconducteurs tridimensionnels opposées au support et les deuxièmes zones actives sur les extrémités des deuxièmes éléments semiconducteurs tridimensionnels opposées au support ;
e) former les deuxième, troisième et quatrième couches conductrices électriquement ;
f) retirer le support ; et
g) former la première couche conductrice électriquement.

Selon un mode de réalisation, l'étape a) comprend les étapes suivantes entre les étapes c) et d) :
h) former une couche isolante électriquement entre les premiers éléments semiconducteurs tridimensionnels et entre les deuxièmes éléments semiconducteurs tridimensionnels ;
i) graver partiellement la couche isolante électriquement et les premiers et deuxièmes éléments semiconducteurs tridimensionnels de sorte que les premiers et deuxièmes éléments semiconducteurs tridimensionnels aient la même hauteur.

Selon un mode de réalisation, le procédé comprend, en outre, entre les étapes f) et g), l'étape de gravure de la couche isolante électriquement et des premiers et deuxièmes éléments semiconducteurs tridimensionnels du côté opposé aux premières et deuxièmes zones actives.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un mode de réalisation d'un dispositif optoélectronique à microfils ou nanofils ;
la figure 2 est une vue de détail d'une partie de la figure 1 ;
les figures 3 à 7 sont des vues analogues à la figure 2 d'autres modes de réalisation du dispositif optoélectronique ; et
les figures 8A à 8Q sont des coupes, partielles et schématiques, des structures obtenues à des étapes successives d'un mode de réalisation d'un procédé de fabrication du dispositif optoélectronique de la figure 1.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des diodes électroluminescentes du dispositif optoélectronique sont bien connus et ne sont pas décrits.

Dans la description qui suit, lorsque l'on fait référence à des qualificatifs de position relative, tels que les termes "dessus", "dessous", "supérieur", "inférieur", etc., , il est fait référence à l'orientation des figures ou à un dispositif optoélectronique dans une position normale d'utilisation. Sauf indication contraire, les termes "sensiblement", "environ", "approximativement" et "de l'ordre de" signifient "à 10 % près", de préférence à 5 % près.

La présente demande concerne notamment des dispositifs optoélectroniques comprenant des éléments tridimensionnels, par exemple des microfils, des nanofils, des éléments coniques ou des éléments tronconiques. En particulier, un élément conique ou tronconique peut être un élément conique ou tronconique de révolution ou un élément conique ou tronconique pyramidal. Dans la suite de la description, des modes de réalisation sont notamment décrits pour des dispositifs optoélectroniques à microfils ou à nanofils. Toutefois, ces modes de réalisation peuvent être mis en oeuvre pour des éléments tridimensionnels autres que des microfils ou des nanofils, par exemple des éléments tridimensionnels coniques ou tronconiques.

Le terme "microfil", "nanofil", "élément conique" ou "élément tronconique" désigne une structure tridimensionnelle de forme allongée selon une direction privilégiée dont au moins deux dimensions, appelées dimensions mineures, sont comprises entre 5 nm et 2,5 µm, de préférence entre 50 nm et 1 µm, la troisième dimension, appelée dimension majeure, étant supérieure ou égale à 1 fois, de préférence supérieure ou égale à 5 fois, la plus grande des dimensions mineures.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil. On définit ici le diamètre du fil comme étant une grandeur associée au périmètre du fil au niveau d'une section droite. Il peut s'agir du diamètre d'un disque présentant la même surface que la section droite du fil. Le diamètre local, également appelé diamètre par la suite, est le diamètre du fil à une hauteur donnée de celui-ci suivant l'axe du fil. Le diamètre moyen est la moyenne, par exemple arithmétique, des diamètres locaux le long du fil ou d'une portion de celui-ci.

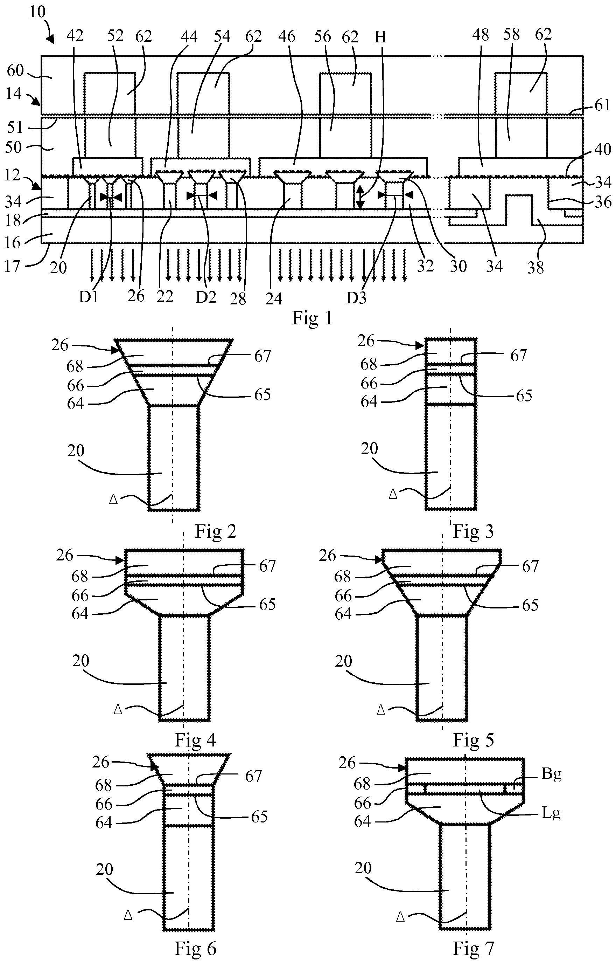

La figure 1 est une coupe, partielle et schématique, d'un dispositif optoélectronique 10 réalisé à partir de fils tels que décrits précédemment et adapté à l'émission d'un rayonnement électromagnétique. Selon un mode de réalisation, il est prévu un dispositif optoélectronique 10 comprenant au moins deux circuits intégrés 12 et 14, également appelés puces. Le premier circuit intégré 12 comprend des diodes électroluminescentes. Le deuxième circuit intégré 14 comprend des composants électroniques, notamment des transistors, utilisés pour la commande des diodes électroluminescentes du premier circuit intégré 12. Le premier circuit intégré 12 est fixé au deuxième circuit intégré, par exemple par collage moléculaire ou par une liaison de type "Flip-Chip", notamment un procédé "Flip-Chip" par billes ou par microtubes. Le premier circuit intégré 12 est appelé circuit optoélectronique ou puce optoélectronique dans la suite de la description et le deuxième circuit intégré 14 est appelé circuit de commande ou puce de commande dans la suite de la description.

De préférence, la puce optoélectronique 12 comprend seulement des diodes électroluminescentes et des éléments de connexion de ces diodes électroluminescentes et la puce de commande 14 comprend la totalité des composants électroniques nécessaires à la commande des diodes électroluminescentes de la puce optoélectronique. A titre de variante, la puce optoélectronique 12 peut également comprendre d'autres composants électroniques en plus des diodes électroluminescentes.

La figure 1 représente, en partie gauche, les éléments de la puce optoélectronique 12 pour un pixel d'affichage, la structure étant répétée pour chaque pixel d'affichage, et en partie droite, des éléments adjacents aux pixels d'affichage et qui peuvent être communs à plusieurs pixels d'affichage.

La puce optoélectronique 12 comprend, du bas vers le haut en figure 1 :
une couche isolante électriquement 16, au moins partiellement transparente aux rayonnements électromagnétiques émis par les diodes électroluminescentes et qui délimite une face 17 ;
une couche conductrice électriquement 18, au moins partiellement transparente aux rayonnements électromagnétiques émis par les diodes électroluminescentes ;
des premiers fils 20 (trois premiers fils étant représentés), de hauteur H, et de diamètre D1, des deuxièmes fils 22 (trois deuxièmes fils étant représentés), de hauteur H, et de diamètre D2 et des troisièmes fils 24 (trois deuxièmes fils étant représentés), de hauteur H, et de diamètre D3, les premiers, deuxièmes et troisièmes fils étant d'axes parallèles et perpendiculaires à la face 17, s'étendant depuis la couche conductrice 18 et au contact de la couche conductrice 18, le diamètre D1 étant inférieur au diamètre D2 et le diamètre D2 étant inférieur au diamètre D3 ;
une première tête 26 à l'extrémité de chaque premier fil 20 opposée à la couche conductrice 18, une deuxième tête 28 à une extrémité de chaque deuxième fil 22 opposée à la couche conductrice 18 et une troisième tête 30 à une extrémité de chaque troisième fil 24 opposée à la couche conductrice 18 ;
une couche isolante électriquement 32 d'un premier matériau isolant électriquement entre les fils 20, 22, 24 ayant une épaisseur sensiblement égale à la somme de la hauteur H et de la dimension de la tête 26 mesurée selon l'axe des fils ;
une couche isolante électriquement 34 d'un deuxième matériau isolant électriquement, qui peut être différent du premier matériau isolant ou identique au premier matériau isolant, s'étendant autour de la première couche isolante 32 et de même épaisseur que la couche isolante 32 ;
une ouverture 36 s'étendant au travers de la couche isolante 34 sur toute l'épaisseur de la couche isolante 34 ;
une couche conductrice électriquement 38 s'étendant dans l'ouverture 36 et étant en contact avec la couche conductrice 18 ;
des portions 40 disjointes d'un matériau conducteur électriquement sur la couche isolante 32, la couche isolante 34, la couche conductrice 38 et les parties des têtes 26, 28 et 30 en saillie par rapport à la couche isolante 32 et notamment en contact avec les parties des têtes 26, 28 et 30 en saillie par rapport à la couche isolante 32 ;
des couches conductrices électriquement 42, 44, 46, 48 et distinctes, la couche conductrice 42 étant au contact des premières têtes 26, la couche conductrice 44 étant au contact des deuxièmes têtes 28, la couche conductrice 46 étant au contact des troisièmes têtes 30 et la couche conductrice 48 étant au contact de la couche conductrice 38 ;
une couche isolante électriquement 50 recouvrant les couches conductrices 42, 44, 46 et 48 et s'étendant entre les couches conductrices 42, 44, 46 et 48 et délimitant une face 51, de préférence sensiblement plane ; et
des plots conducteurs électriquement 52, 54, 56, 58, pouvant avoir une structure multicouche, s'étendant au travers de la couche isolante 50 et affleurant sur la face 51, le plot conducteur 52 étant au contact de la couche conductrice 42, le plot conducteur 54 étant au contact de la couche conductrice 44, le plot conducteur 56 étant au contact de la couche conductrice 46 et le plot conducteur 58 étant au contact de la couche conductrice 48.

La puce de commande 14 comprend notamment du côté de la puce optoélectronique 12 une couche isolante électriquement 60 délimitant une face 61, de préférence sensiblement plane, et des plots conducteurs 62 affleurant sur la face 61, les plots conducteurs 62 étant reliés électriquement aux plots conducteurs 52, 54, 56, 58. Dans le cas où la puce de commande 14 est fixée à la puce optoélectronique 12 par collage moléculaire, les plots conducteurs 62 peuvent être en contact avec les plots conducteurs 52, 54, 56, 58. Dans le cas où la puce de commande 14 est fixée à la puce optoélectronique 12 par une liaison de type "flip chip", des billes de soudure ou des microtubes peuvent être interposés entre les plots conducteurs 62 et les plots conducteurs 52, 54, 56, 58.

Les figures 2 à 8 sont des vues de détail de modes de réalisation de la tête 26. Les têtes 28 et 30 peuvent avoir une structure analogue à la tête 26.

En figure 2, la tête 26 comprend successivement en s'éloignant du fil 20 selon l'axe Δ du fil 20 :
une portion semiconductrice 64 du même matériau que le fil 20 et dopée d'un premier type de conductivité, par exemple de type N ;
une zone active 66 ; et
une portion semiconductrice 68 dopée d'un second type de conductivité, par exemple de type P.
Une couche de passivation, non représentée, peut être présente sur les flancs latéraux de la zone active 66 et des portions semiconductrices 64, 68.

L'ensemble formé par chaque fil 20, 22, 24 et la tête 26, 28, 30 associée constitue une diode électroluminescente élémentaire filaire en configuration axiale. La tête 26, 28, 30 comprend notamment une zone active 66 qui est la couche depuis laquelle est émise la majorité du rayonnement électromagnétique fourni par la diode électroluminescente. Selon un exemple, la zone active 66 peut comporter des moyens de confinement tels que des puits quantiques multiples.

La diode électroluminescente est dite en configuration axiale dans la mesure où la zone active 66 revêt essentiellement une face 65 de la portion semiconductrice 64 sensiblement orthogonale à l'axe Δ, et s'étend suivant l'axe Δ. De plus, la portion semiconductrice 68 revêt essentiellement une face 67 supérieure de la zone active 66 sensiblement orthogonale à l'axe Δ, et s'étend suivant l'axe Δ.

Dans le mode de réalisation représenté sur la figure 2, la section droite de la tête 26 augmente au fur et à mesure que l'on s'éloigne du fil 20 et les portions semiconductrices 68 de diodes électroluminescentes adjacentes sont distinctes. Selon un autre mode de réalisation, les portions semiconductrices 68 de diodes électroluminescentes adjacentes peuvent coalescer.

La figure 3 est une vue analogue à la figure 2 d'un autre mode de réalisation dans lequel la section droite de la tête 26 est sensiblement constante.

La figure 4 est une vue analogue à la figure 2 d'un autre mode de réalisation dans lequel la section droite de la tête 26 augmente au fur et à mesure que l'on s'éloigne du fil 20 puis reste sensiblement constante, la zone active 66 étant située au niveau de la partie de section constante de la tête 26.

La figure 5 est une vue analogue à la figure 4 d'un autre mode de réalisation dans lequel la section droite de la tête 26 augmente au fur et à mesure que l'on s'éloigne du fil 20 puis reste sensiblement constante, la zone active 66 étant située au niveau de la partie de section croissante de la tête 26.

La figure 6 est une vue analogue à la figure 2 d'un autre mode de réalisation dans lequel la section droite de la tête 26 est sensiblement constante pour la portion semiconductrice 64 et la zone active 66 et augmente pour la portion semiconductrice 68 au fur et à mesure que l'on s'éloigne du fil 20.

Selon un mode de réalisation, chaque pixel d'affichage Pix comprend au moins deux types de diodes électroluminescentes. Selon un mode de réalisation, les diodes électroluminescentes du premier type, comprenant par exemple les fils 20 et les têtes 26, sont adaptées à émettre un premier rayonnement à une première longueur d'onde et les diodes électroluminescentes du deuxième type, comprenant par exemple les fils 22 et les têtes 28, sont adaptées à émettre un deuxième rayonnement à une deuxième longueur d'onde. Selon un mode de réalisation, chaque pixel d'affichage Pix comprend au moins trois types de diodes électroluminescentes, les diodes électroluminescentes du troisième type, comprenant par exemple les fils 24 et les têtes 30, étant adaptées à émettre un troisième rayonnement à une troisième longueur d'onde. Les première, deuxième et troisième longueurs d'ondes peuvent être différentes.

Selon un mode de réalisation, notamment dans le cas où la face 65 de la portion semiconductrice 64 correspond seulement à un plan cristallographique C, la longueur d'onde du rayonnement émis par la zone active 66 augmente lorsque le diamètre du fil 20, 22, 24 sur lequel repose la zone active 66 diminue. Selon un mode de réalisation, la troisième longueur d'onde correspond à de la lumière bleue et est dans la plage de 430 nm à 490 nm. Selon un mode de réalisation, la deuxième longueur d'onde correspond à de la lumière verte et est dans la plage de 510 nm à 570 nm. Selon un mode de réalisation, la première longueur d'onde correspond à de la lumière rouge et est dans la plage de 600 nm à 720 nm. Ceci est surprenant dans la mesure où il est généralement décrit que, lorsque la zone active 66 croît sur des plans cristallographiques semi-polaires, la longueur d'onde du rayonnement émis par la zone active augmente lorsque le diamètre du fil sur lequel repose la zone active 66 augmente.

Selon un mode de réalisation, chaque pixel d'affichage Pix comprend des diodes électroluminescentes d'un quatrième type, les diodes électroluminescentes du quatrième type étant adaptées à émettre un quatrième rayonnement à une quatrième longueur d'onde. Les première, deuxième, troisième et quatrième longueurs d'ondes peuvent être différentes. Selon un mode de réalisation, la quatrième longueur d'onde correspond à de la lumière jaune et est dans la plage de 570 nm à 600 nm.

Pour chaque pixel d'affichage, les diodes électroluminescentes élémentaires ayant des fils de même diamètre sont à électrodes communes et lorsqu'une tension est appliquée entre la couche conductrice 18 et la couche conductrice 42, 44 ou 46, un rayonnement lumineux est émis par les zones actives de ces diodes électroluminescentes élémentaires.

Dans le présent mode de réalisation, le rayonnement électromagnétique émis par chaque diode électroluminescente s'échappe du dispositif optoélectronique 12 par la face 17. De préférence, chaque couche conductrice 42, 44, 46 est réfléchissante et permet, de façon avantageuse, d'augmenter la proportion du rayonnement émis par les diodes électroluminescentes qui s'échappe du dispositif optoélectronique 10 par la face 17.

La puce optoélectronique 12 et la puce de commande 14 étant empilées, l'encombrement latéral du dispositif optoélectronique 10 est réduit. Selon un mode de réalisation, la dimension latérale d'un pixel d'affichage, mesurée perpendiculairement aux axes des fils est inférieure à 5 µm, de préférence inférieure à 4 µm, par exemple environ 3 µm. De plus, la puce optoélectronique 12 peut avoir les mêmes dimensions que la puce de commande 14. De ce fait, la compacité du dispositif optoélectronique 10 peut, de façon avantageuse, être augmentée.

La couche conductrice 18 est adaptée à polariser les zones actives des têtes 26, 28, 30 et à laisser passer le rayonnement électromagnétique émis par les diodes électroluminescentes. Le matériau formant la couche conductrice 18 peut être un matériau transparent et conducteur tel que du graphène ou un oxyde transparent et conducteur (ou TCO, sigle anglais pour Transparent Conducting Oxide), notamment l'oxyde d'indium-étain (ou ITO, sigle anglais pour Indium Tin Oxide), de l'oxyde de zinc dopé ou non à l'aluminium, ou au gallium ou au bore. A titre d'exemple, la couche conductrice 18 a une épaisseur comprise entre 20 nm et 500 nm, de préférence entre 20 nm et 100 nm.

La couche conductrice 38, les couches conductrices 42, 44, 46, 48 et les plots conducteurs 52, 54, 56, 58 peuvent être en métal, par exemple en aluminium, en argent, en cuivre, en or ou en ruthénium ou en un alliage d'au moins deux de ces composés. La couche conductrice 38 peut avoir une épaisseur comprise entre 100 nm et 3 µm. Les couches conductrices 42, 44, 46, 48 peuvent avoir une épaisseur comprise entre 100 nm et 2 µm. La dimension latérale minimale, dans un plan perpendiculaire à la face 17, est comprise entre 150 nm et 1 µm, par exemple environ 0,25 µm. Les plots conducteurs 52, 54, 56, 58 peuvent avoir une épaisseur comprise entre 0,5 µm et 2 µm.

Chacune des couches isolantes 16, 32, 34 et 50 est en un matériau choisi dans le groupe comprenant l'oxyde de silicium (SiO₂), le nitrure de silicium (SiₓN_{y}, où x est environ égal à 3 et y est environ égal à 4, par exemple du Si₃N₄), l'oxynitrure de silicium (notamment de formule générale SiOₓN_{y}, par exemple du Si₂ON₂), l'oxyde d'hafnium (HfO₂) ou l'oxyde d'aluminium (Al₂O₃). Selon un mode de réalisation, la couche isolante 74 est en oxyde de silicium et la couche isolante 76 est en nitrure de silicium. L'épaisseur de chaque couche isolante 74, 76 est comprise entre 10 nm et 100 nm, de préférence entre 20 nm et 60 nm, notamment égale à environ 40 nm. La couche isolante 16 peut avoir une épaisseur maximale comprise entre 100 nm et 5 µm. Les couches isolantes 32 et 34 peuvent avoir une épaisseur maximale comprise entre 0,5 µm et 2 µm. La couche isolante 50 peut avoir une épaisseur maximale comprise entre 0,5 µm et 2 µm.

Les portions conductrices 40 sont en un matériau qui est à la fois un bon conducteur électrique et qui présente une meilleure résistance de contact avec le matériau composant la couche supérieure des têtes 26, 28, 30 que le matériau composant les couches conductrices 42, 44, 46, 48. Les portions conductrices 40 sont par exemple en nickel (Ni). Les portions conductrices 40 peuvent avoir une épaisseur comprise entre 0,5 nm et 10 nm. Les portions conductrices 40 permettent d'obtenir un contact faiblement résistif entre les têtes 26, 28, 30 et les couches conductrices 42, 44, 46.

Chaque fil 20, 22, 24 et chaque portion semiconductrice 64, 68 sont, au moins en partie, formés à partir d'au moins un matériau semiconducteur. Selon un mode de réalisation, le matériau semiconducteur est choisi dans le groupe comprenant les composés III-V, les composés II-VI ou les semiconducteurs ou composés du groupe IV.

Les fils 20, 22, 24 et les portions semiconductrices 64, 68 peuvent être, au moins en partie, formés à partir d'un premier matériau semiconducteur comportant majoritairement un composé III-V, par exemple un composé III-N, un composé II-VI ou au moins un élément du groupe IV. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires. Des exemples de matériaux semiconducteurs du groupe IV sont le silicium (Si), le carbone (C), le germanium (Ge), les alliages de carbure de silicium (SiC), les alliages silicium-germanium (SiGe) ou les alliages de carbure de germanium (GeC). Le matériau semiconducteur des fils 20, 22, 24 et/ou des portions semiconductrices 64, 68 peut comporter un dopant, par exemple du silicium assurant un dopage de type N d'un composé III-N, ou du magnésium assurant un dopage de type P d'un composé III-N.

Chaque fil 20, 22, 24 peut avoir une structure semiconductrice allongée selon un axe sensiblement perpendiculaire à la face 17. Chaque fil 20, 22, 24 peut avoir une forme générale cylindrique. Les axes de deux fils 20, 22, 24 adjacents peuvent être distants de 100 nm à 3 µm et de préférence de 200 nm à 1,5 µm. La hauteur H de chaque fil 20, 22, 24 peut être comprise entre 150 nm et 10 µm, de préférence entre 200 nm et 1 µm, plus préférentiellement entre 250 nm et 750 nm. Le diamètre moyen de chaque fil 20, 22, 24 peut être compris entre 50 nm et 10 µm, de préférence entre 100 nm et 2 µm, plus préférentiellement entre 120 nm et 1 µm.

La section droite des fils 20, 22, 24 peut avoir différentes formes, telles que, par exemple, une forme ovale, circulaire ou polygonale, notamment triangulaire, rectangulaire, carrée ou hexagonale.

La zone active 66 peut comprendre au moins un puits quantique, comprenant une couche d'un deuxième matériau semiconducteur présentant une énergie de bande interdite inférieure à celle de la portion semicondutrice 64 et de la portion semiconductrice 68, de préférence interposée entre deux couches barrières, améliorant ainsi le confinement des porteurs de charge. Le deuxième matériau semiconducteur peut comprendre le composé III-V, II-VI ou IV des portions semiconductrices dopées 64, 68 dans lequel est incorporé au moins un élément supplémentaire. A titre d'exemple, dans le cas d'un fil 20, 22, 24 réalisé à base de GaN, le deuxième matériau formant le puits quantique est préférentiellement de l'InGaN. Le pourcentage atomique de l'élément supplémentaire est fonction des propriétés optiques recherchées et du spectre d'émission du fil. La zone active 66 peut être formée d'un unique puits quantique ou de plusieurs puits quantiques.

Selon un mode de réalisation préféré, chaque fil 20, 22, 24 est réalisé à base de GaN, le ou les puits quantiques de la zone active 66 étant réalisés en InGaN. La longueur d'onde d'émission de la zone active 66 dépend notamment de la proportion d'indium dans le ou les puits quantiques. La portion semiconductrice 64 peut être formée de GaN, et être dopée du premier type de conductivité, par exemple de type N, notamment par du silicium. La hauteur de la portion semiconductrice 64, mesurée selon l'axe Δ, peut être comprise entre 10 nm et 1 µm, par exemple comprise entre 20 nm et 200 nm. La zone active 66 peut comprendre un ou plusieurs puits quantiques, par exemple réalisés en InGaN. La zone active 66 peut comprendre un unique puits quantique qui s'étend continûment suivant l'axe Δ entre les portions semiconductrices 64, 68. Alternativement, elle peut comprendre des puits quantiques multiples et est alors formée d'une alternance, suivant l'axe Δ, de puits quantiques réalisés par exemple en InGaN, et de couches barrières réalisées par exemple en GaN. La hauteur de la zone active 66, mesurée selon l'axe Δ, peut être comprise entre 10 nm et 500 nm, par exemple comprise entre 20 nm et 100 nm. La portion semiconductrice 68 peut être formée de GaN, et être dopée du second type de conductivité opposé au premier, par exemple de type P, notamment par du magnésium. La hauteur de la portion semiconductrice 68 peut être comprise entre 50 nm et 5 µm, par exemple comprise entre 100 nm et 1 µm. La portion semiconductrice 68 peut comprendre une couche de blocage d'électrons située à l'interface avec la zone active 66. La couche de blocage d'électrons peut être formée d'un composé ternaire III-N, par exemple de l'AlGaN ou de l'AlInN, avantageusement dopée P. Elle permet d'accroître le taux de recombinaisons radiatives au sein de la zone active 66.

Dans les modes de réalisation représentés sur les figures 2 à 7, les couches formant la zone active 66 sont empilées selon l'axe Δ.

La figure 7 est une vue analogue à la figure 4 d'un autre mode de réalisation dans lequel la zone active 66 comprend une portion centrale Lg d'un matériau semiconducteur ayant une première bande interdite et une portion périphérique Bg disposée autour de la portion centrale selon l'axe Δ et au contact de la portion centrale, la portion périphérique étant en un matériau semiconducteur ayant une deuxième bande interdite supérieure à la première bande interdite.

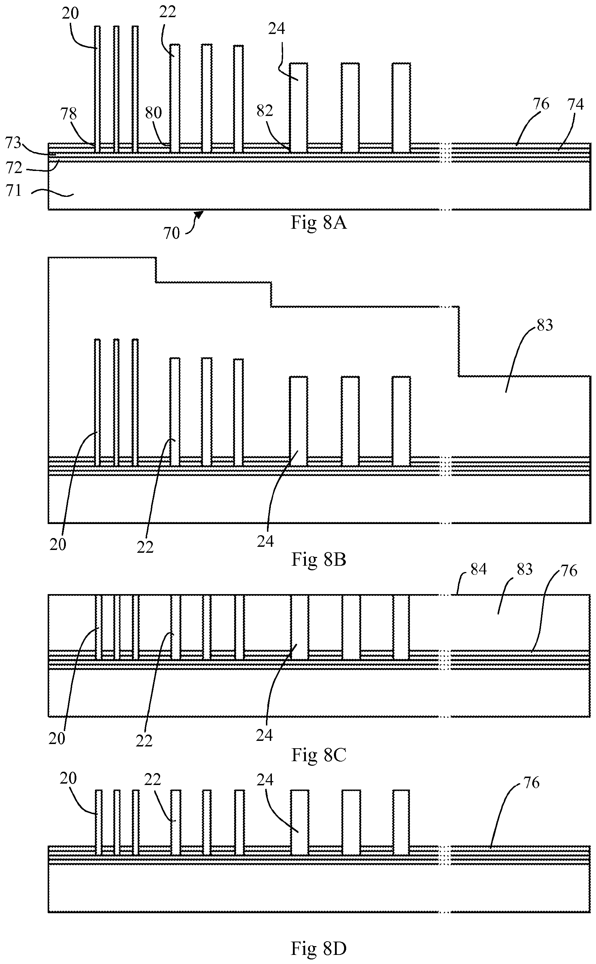

Les figures 8A à 8Q sont des vues en coupe, partielles et schématiques, des structures obtenues à des étapes successives d'un mode de réalisation d'un procédé de fabrication du dispositif optoélectronique 10 représenté en figure 1.

La figure 8A représente la structure obtenue après les étapes suivantes :
former un support 70 correspondant à l'empilement, du bas vers le haut en figure 8A, d'un substrat 71, au moins d'une couche de nucléation, également appelée couche de germination, deux couches de nucléation 72 et 73 étant représentées à titre d'exemple en figure 8A, d'une couche isolante électriquement 74 et d'une couche isolante électriquement 76 sur la couche isolante 74, les couches isolantes 74, 76 étant en des matériaux différents ;
former des premières ouvertures 78 dans les couches isolantes 74 et 76 pour exposer des parties de la couche de nucléation 73 aux emplacements souhaités des premiers fils 20, le diamètre des premières ouvertures 78 correspondant sensiblement au diamètre des premiers fils 20, des deuxièmes ouvertures 80 dans les couches isolantes 74 et 76 pour exposer des parties de la couche de nucléation 73 aux emplacements souhaités des deuxièmes fils 22, le diamètre des deuxièmes ouvertures 80 correspondant sensiblement au diamètre des deuxièmes fils 22, et des troisièmes ouvertures 82 dans les couches isolantes 74 et 76 pour exposer des parties de la couche de nucléation 73 aux emplacements souhaités des troisièmes fils 24, le diamètre des troisièmes ouvertures 82 correspondant sensiblement au diamètre des troisièmes fils 24 ; et
faire croître simultanément les fils 20, 22, 24 depuis la couche de nucléation 72 dans les ouvertures 78, 80, 82.

A titre de variante, les couches isolantes 74, 76 peuvent être remplacées par une couche isolante unique.

Le substrat 71 peut correspondre à une structure monobloc ou correspondre à une couche recouvrant un support constitué d'un autre matériau. Le substrat 71 est de préférence un substrat semiconducteur, par exemple un substrat en silicium, en germanium, en carbure de silicium, en un composé III-V, tel que du GaN ou du GaAs, ou un substrat en ZnO, ou un substrat conducteur, par exemple un substrat en un métal ou un alliage métallique, notamment le cuivre, le titane, le molybdène, un alliage à base de nickel et l'acier. De préférence, le substrat 71 est un substrat de silicium monocristallin. De préférence, il s'agit d'un substrat semiconducteur compatible avec les procédés de fabrication mis en oeuvre en microélectronique. Le substrat 71 peut correspondre à une structure multicouches de type silicium sur isolant, également appelée SOI (acronyme anglais pour Silicon On Insulator). Le substrat 71 peut être fortement dopé, faiblement dopé ou non dopé.

Les couches de nucléation 72, 73 sont en un matériau qui favorise la croissance des fils 20, 22, 24. Le matériau composant chaque couche de nucléation 72, 73 peut être un métal, un oxyde métallique, un nitrure, un carbure ou un borure d'un métal de transition de la colonne IV, V ou VI du tableau périodique des éléments ou une combinaison de ces composés et de préférence un nitrure d'un métal de transition de la colonne IV, V ou VI du tableau périodique des éléments ou une combinaison de ces composés. A titre d'exemple, chaque couche de germination 72, 73 peut être en nitrure d'aluminium (AlN), en oxyde d'aluminium (Al₂O₃), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), ou en nitrure de magnésium sous la forme MgₓN_{y}, où x est environ égal à 3 et y est environ égal à 2, par exemple du nitrure de magnésium selon la forme Mg₃N₂. Chaque couche de nucléation 72, 73 a, par exemple, une épaisseur comprise entre 1 nm et 100 nm, de préférence comprise entre 10 nm et 30 nm.

Chacune des couches isolantes 74 et 76 est en un matériau choisi dans le groupe comprenant l'oxyde de silicium (SiO₂), le nitrure de silicium (SiₓN_{y}, où x est environ égal à 3 et y est environ égal à 4, par exemple du Si₃N₄), l'oxynitrure de silicium (notamment de formule générale SiOₓN_{y}, par exemple du Si₂ON₂), l'oxyde d'hafnium (HfO₂) ou l'oxyde d'aluminium (Al₂O₃). Selon un mode de réalisation, la couche isolante 74 est en oxyde de silicium et la couche isolante 76 est en nitrure de silicium. L'épaisseur de chaque couche isolante 74, 76 est comprise entre 10 nm et 100 nm, de préférence entre 20 nm et 60 nm, notamment égale à environ 40 nm.

Le procédé de croissance des fils 20, 22, 24 peut être un procédé du type dépôt chimique en phase vapeur (CVD, sigle anglais pour Chemical Vapor Déposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. De plus, des procédés électrochimiques peuvent également être utilisés, par exemple, le dépôt en bain chimique (CBD, sigle anglais pour Chemical Bath Déposition), les procédés hydrothermiques (également appelés procédés hydrothermaux), la pyrolyse d'aérosol liquide ou l'électrodépôt.

A titre d'exemple, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMA1). Des exemples de précurseurs d'éléments du groupe V sont l'ammoniac (NH₃), le tertiarybutylphoshine (TBT), l'arsine (AsH₃) ou le diméthylhydrazine (UDMH).

La hauteur de chaque fil 20, 22, 24 à la fin de l'étape de croissance peut être comprise entre 250 nm et 15 µm, de préférence entre 500 nm et 5 µm, plus préférentiellement entre 1 µm et 3 µm. La hauteur des premiers fils 20 est différente de la hauteur des deuxièmes fils 24 et de la hauteur des troisièmes fils 24. La hauteur des fils 20, 22, 24 dépend notamment du diamètre du fil et de l'écart entre les fils. Selon un mode de réalisation, la hauteur des premiers fils 20 est supérieure à la hauteur des deuxièmes fils 22 et la hauteur des deuxièmes fils 22 est supérieure à la hauteur des troisièmes fils 24.

Chaque couche de nucléation 72, 73 et chaque couche isolante 74, 76 peut être déposée à titre d'exemple par dépôt chimique en phase vapeur assisté par plasma (PECVD, sigle anglais pour Plasma-Enhanced Chemical Vapor Déposition), dépôt chimique en phase vapeur à basse pression (LPCVD, sigle anglais pour Low-Pressure Chemical Vapor Déposition), dépôt chimique en phase vapeur à pression sous-atmosphérique (SACVD, sigle anglais pour Sub-Atmospheric Chemical Vapor Déposition), CVD, dépôt physique en phase vapeur (PVD, sigle anglais pour Physical Vapor Déposition), ou dépôt par couches atomiques (ALD, sigle anglais pour Atomic Layer Déposition).

La figure 8B représente la structure obtenue après avoir déposé une couche diélectrique 83 sur la totalité des fils 20, 22, 24 et sur la couche isolante 76 entre les fils 20, 22, 24.

La couche diélectrique 83 peut être du même matériau que la couche isolante 74, c'est-à-dire en un matériau différent de la couche isolante 76. Selon un mode de réalisation, l'épaisseur minimale de la couche 83 est supérieure à la hauteur des plus petits fils 20, 22, 24. De préférence, l'épaisseur minimale de la couche 83 est supérieure à la hauteur des plus grands fils 20, 22, 24.

A titre d'exemple, l'épaisseur de la couche diélectrique 83 est comprise entre 250 nm et 15 µm, de préférence entre 300 nm et 5 µm, par exemple égale à environ 2 µm. La couche isolante 83 peut être formée par les mêmes procédés que ceux utilisés pour la formation des couches isolantes 72, 74.

La figure 8C représente la structure obtenue après avoir aminci et planarisé la couche isolante 83 et une partie des fils 20, 22, 24 pour délimiter une face 84 plane à une hauteur de la couche de germination 76 par exemple comprise entre 150 nm et 10 µm. La gravure est par exemple une planarisation mécano-chimique ou CMP (sigle anglais pour Chemical-Mechanical Planarization). La présence de la couche isolante 83 entre les fils 20, 22, 24 permet de mettre en oeuvre un procédé de gravure de type CMP, ce qui serait difficile, voire impossible, si seuls les fils étaient présents. Après cette étape, tous les fils 20, 22, 24 ont la même hauteur. La gravure de la couche isolante 83 et d'une partie des fils 20, 22, 24 peut être réalisée en plusieurs étapes. A titre de variante, l'étape d'amincissement et de planarisation de la couche isolante 83 et d'une partie des fils 20, 22, 24 peut ne pas être présente lorsque les fils 20, 22, 24 ont sensiblement la même hauteur.

La figure 8D représente la structure obtenue après avoir retiré complétement la couche diélectrique 83 pour exposer la couche isolante 76 et les fils 20, 22, 24. La couche isolante 76 peut alors jouer le rôle de couche d'arrêt lors de la gravure de la couche diélectrique 83. Le retrait de la couche diélectrique 83 peut être réalisé par une gravure humide. A titre de variante, la gravure de la couche diélectrique 83 peut être seulement partielle, une couche résiduelle étant conservée sur la couche isolante 76.

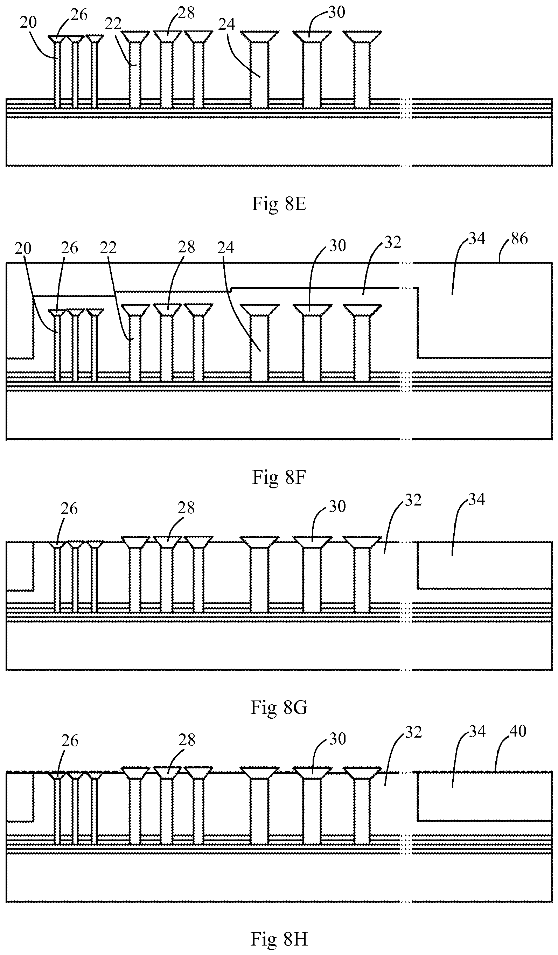

La figure 8E représente la structure obtenue après la formation simultanée des têtes 26, 28, 30 pour chaque fil 20, 22, 24. Les couches successives formant les têtes peuvent être réalisées par les mêmes procédés que ceux décrits pour la formation des fils 20, 22, 24. De tels procédés sont décrits dans la publication de Katsumi Kishino et al intitulée "Monolithic Integration of InGaN-Based Nanocolumn Light-Emitting Diodes with Différent Emision Colors" (2013, The Japan Society of Applied Physics, Applied Physics Express 6 (2013) 012101) et la publication de Yong-Ho Ra intitulée "Full-Color Single Nanowire Pixels for Projection Displays".

La formation des zones actives des têtes 26, 28, 30 peut comprendre, en plus de l'injection dans le réacteur d'un précurseur d'un élément du groupe III et d'un précurseur d'un élément du groupe V, un précurseur d'un élément supplémentaire, notamment de l'indium. Le taux d'incorporation de l'élément supplémentaire dans la zone active 66 dépend notamment des dimensions latérales des zones actives, de l'écart entre les fils 20, 22, 24, de la hauteur des zones actives vis-à-vis de la surface supérieure de la couche diélectrique 83 (si celle-ci n'est pas gravée complètement) ou bien de la couche isolante 76 (si la couche diélectrique 83 est gravée complétement). On obtient ainsi des taux d'incorporation d'indium différents pour les zones actives des têtes 26, 28, 30, bien qu'elles soient formées simultanément. En fonctionnement, les têtes 26, 28, 30 sont alors adaptées à émettre des rayonnements électromagnétiques à des longueurs d'onde différentes.

Si la couche diélectrique 83 était maintenue entre les fils 20, 22, 24, les procédés mis en oeuvre pour la formation des têtes 26, 28, 30 pourraient entraîner également la formation de cristaux indésirables sur la couche diélectrique 83. Le retrait au moins partiel de la couche diélectrique 83 fait qu'il y a peu de formation de cristaux parasites sur les parois latérales des fils et au pied des fils notamment en raison de l'effet d'écran dû à l'ensemble des fils.

La figure 8F représente la structure obtenue après les étapes suivantes :
formation de la couche isolante 32 ;
formation de la couche isolante 34 ; et
gravure ou amincissement de la couche isolante 34 sur une partie de son épaisseur pour délimiter une face sensiblement plane 86.

La couche isolante 32 peut être réalisée par un dépôt conforme, par exemple par LPCVD. Le procédé de formation de la couche isolante 32 est de préférence réalisé à une température inférieure à 700 °C pour ne pas endommager les zones actives des diodes électroluminescentes. En outre, un procédé du type LPCVD permet d'obtenir un bon remplissage entre les fils 20, 22, 24. L'épaisseur déposée de la couche isolante 32 peut être comprise entre 50 nm et 500 nm, par exemple environ 150 nm. La couche isolante 34 peut être réalisée par un dépôt conforme, par exemple par PECVD. L'épaisseur déposée de la couche isolante 34 peut être supérieure ou égale à 2 µm. La gravure partielle de la couche isolante 34 peut être réalisée par CMP. L'arrêt de la gravure peut être réalisé dans la couche isolante 34, comme cela est représenté en figure 8F, dans la couche isolante 32 mais de toute façon avant d'exposer les têtes 26, 28, 30.

La figure 8G représente la structure obtenue après avoir gravé les couches isolantes 32, 34 jusqu'à exposer les surfaces supérieures des têtes 26, 28, 30. La gravure est par exemple une gravure du type gravure ionique réactive (RIE, sigle anglais pour Reactive-Ion Etching) ou une gravure à plasma à couplage inductif (ICP, sigle anglais pour Inductively Coupled Plasma). Les têtes 26, 28, 30 pouvant ne pas avoir les mêmes dimensions, certaines têtes 26, 28, 30 peuvent être davantage exposées que d'autres. Les têtes 26, 28, 30 ne sont pas gravées à cette étape. La gravure est de préférence une gravure anisotrope. Des portions non représentées de la couche 32 peuvent être conservées sur les parois latérales des têtes 26, 28, 30. La couche située au sommet des têtes 26, 28, 30 joue le rôle de couche d'arrêt de gravure. Selon un mode de réalisation, lors de la formation des têtes 26, 28, 30, une couche supplémentaire est ajoutée aux sommets des têtes 26, 28, 30 pour jouer le rôle de couche d'arrêt de gravure. Il peut s'agir d'une couche de AlN.

La figure 8H représente la structure obtenue après les étapes suivantes :
lorsque des couches d'arrêt de gravure sont présentes sur les têtes 26, 28, 30, retrait des couches d'arrêt de gravure ; et
formation des portions métalliques 40 sur les parties exposées des têtes 26, 28, 30, sur la couche isolante 32 et sur la couche isolante 34.

Lorsque les couches d'arrêt de gravure sur les têtes 26, 28, 30 sont en AlN, elles peuvent être retirées par une gravure du type hydroxyde de tétraméthylammonium (TMAH). La formation des portions métalliques 40 peut comprendre successivement le dépôt d'une couche métallique de 1 nm d'épaisseur, par exemple du nickel, et une étape de recuit thermique, par exemple à une température de 550 °C, ce qui conduit à la formation des portions disjointes 40.

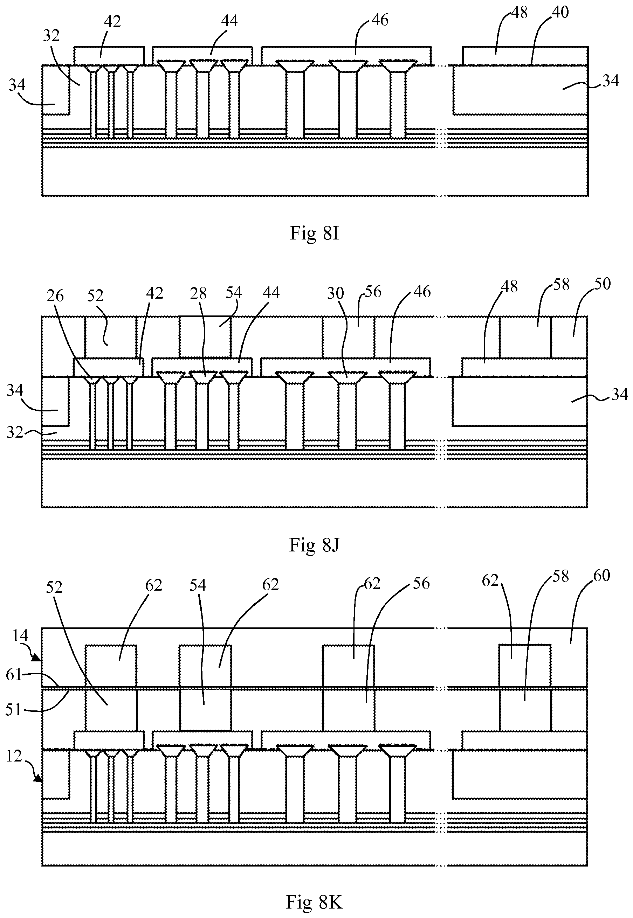

La figure 8I représente la structure obtenue après les étapes suivantes :
dépôt d'une couche métallique sur la structure représentée en figure 8H, par exemple par pulvérisation cathodique, ayant par exemple une épaisseur de 0,5 µm ;
gravure de la couche pour délimiter les couches conductrices 42, 44, 46, 48.

La figure 8J représente la structure obtenue après les étapes suivantes :
dépôt de la couche isolante 50 sur la structure représentée en figure 8I ; et
formation des plots conducteurs 52, 54, 56, 58, par exemple en cuivre.

La figure 8K représente la structure obtenue après avoir fixé la puce de commande 14 à la puce optoélectronique 12. La fixation de la puce de commande 14 à la puce optoélectronique 12 peut être réalisée en utilisant des inserts tels que des microbilles de connexion, non représentées. A titre de variante, la fixation de la puce de commande 14 à la puce optoélectronique peut être réalisée par collage direct, sans utilisation d'inserts. Le collage direct peut comprendre un collage direct métal-métal de zones métalliques, notamment les plots conducteurs 62 de la puce de commande 14 et de zones métalliques, notamment les plots conducteurs 52, 54, 56, 58, de la puce optoélectronique 12 et un collage diélectrique-diélectrique de zones diélectriques, notamment la couche isolante 50, de la puce de commande 14, et de zones diélectriques, notamment la couche isolante 50, de la puce optoélectronique 12. La fixation de la puce de commande 14 à la puce optoélectronique 12 peut être réalisée par un procédé de thermocompression dans lequel la puce optoélectronique 12 est plaquée contre la puce de commande 14, avec application d'une pression et d'un chauffage.

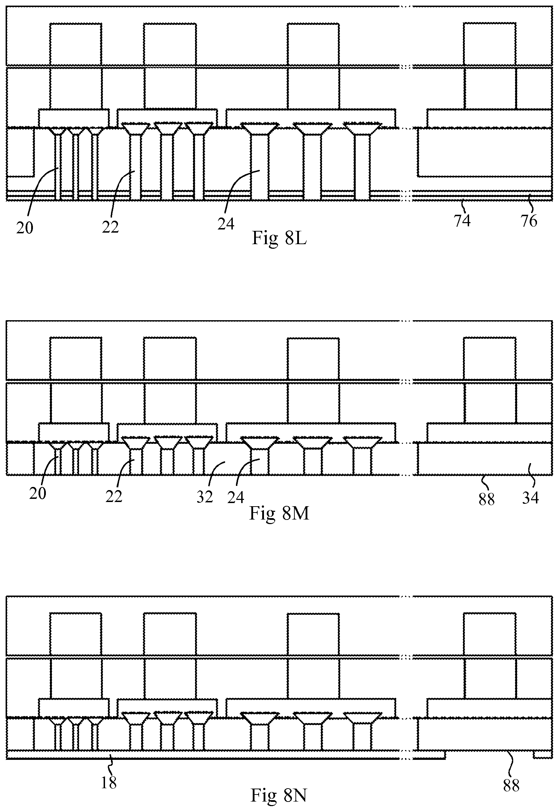

La figure 8L représente la structure obtenue après avoir retiré le substrat 71 et les couches de germination 72, 73. Le retrait du substrat 71 peut être réalisé par meulage et/ou gravure humide. Le retrait des couches de germination 72, 73 peut être réalisé par gravure humide, gravure sèche ou par CMP. La couche isolante 74 ou 76 peut jouer le rôle de couche d'arrêt de gravure lors de la gravure de la couche de germination 73.

La figure 8M représente la structure obtenue après avoir gravé les couches isolantes 74 et 76, après avoir gravé partiellement la couche isolante 32, la couche isolante 34 et les fils 20, 22, 24 pour délimiter une face 88 sensiblement plane. Cette étape de retrait peut être réalisée par CMP. La hauteur restante des fils 20, 22, 24 est égale à la hauteur H, par exemple d'environ 0,5 µm.

La figure 8N représente la structure obtenue après avoir formé la couche conductrice 18 sur la face 88, par exemple en déposant une couche de TCO sur la totalité de la face 88, ayant par exemple une épaisseur de 50 nm, et en gravant cette couche par des techniques de photolithographie pour ne conserver que la couche de TCO 18.

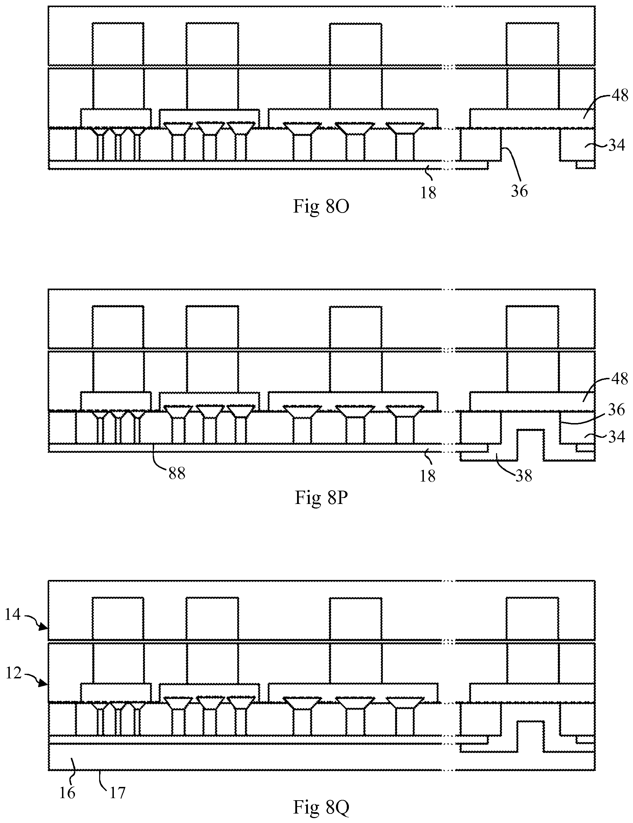

La figure 8O représente la structure obtenue après avoir gravé l'ouverture 36 dans la couche isolante 34 sur toute l'épaisseur de la couche isolante 34 pour exposer la couche conductrice 48. Ceci peut être réalisé par des techniques de photolithographie.

La figure 8P représente la structure obtenue après avoir formé la couche conductrice 38 dans l'ouverture 36 et sur la face 88 au contact de la couche conductrice 18. Ce peut être réalisé en déposant un empilement de couches conductrices, par exemple du type Ti/TiN/AlCu, sur la totalité de la structure du côté de la face 88, et en gravant cette couche par des techniques de photolithographie pour ne conserver que la couche conductrice 38.

La figure 8Q représente la structure obtenue après avoir formé la couche isolante sur la couche conductrice 18 délimitant la face 17. Il s'agit par exemple d'une couche de SiON déposée par PECVD avec une épaisseur de 1 µm.

Une étape supplémentaire de formation de reliefs sur la face 17, également appelée étape de texturation, peut être prévue pour augmenter l'extraction de la lumière.

La diminution de la hauteur des fils par la face arrière peut être réalisée par un procédé de type CMP, comme cela a été décrit précédemment, ou par tout autre procédé de gravure sèche ou de gravure humide. La hauteur des fils, notamment en GaN, obtenue peut être choisie de manière à augmenter l'extraction de la lumière par le pied du fil par des interactions optiques à l'intérieur même du fil. De plus, cette hauteur peut être choisie de manière à favoriser le couplage optique entre les différents fils et donc à augmenter l'émission collective d'un ensemble de fils.

Selon un autre mode de réalisation d'un procédé de fabrication du dispositif optoélectronique, les têtes 26, 28, 30 ne sont pas formées de façon simultanée sur tous les fils 20, 22, 24, mais de façon séquentielle, avec trois étapes de croissance au cours desquelles les fils au sommet desquels des têtes ne doivent pas être formées sont masqués. Les fils 20, 22, 24 peuvent alors tous avoir le même diamètre et le même pas interfil, les zones actives étant formées avec des propriétés différentes, par exemple avec des proportions d'indium différentes, pour obtenir des émissions à des longueurs d'onde différentes.

Des modes de réalisation particuliers viennent d'être décrits. Différentes variantes et modifications apparaîtront à l'homme du métier. On a décrit des structures semiconductrices tridimensionnelles adaptées à émettre un rayonnement lumineux à partir d'un signal électrique, formant ainsi des diodes électroluminescentes. Alternativement, les structures peuvent être adaptées à détecter un rayonnement lumineux incident et à produire en réponse un signal électrique, formant ainsi une photodiode. Les applications peuvent concerner le domaine de l'optoélectronique ou du photovoltaïque.

## Revendications

1. Procédé de fabrication d'un dispositif optoélectronique (10) comprenant un premier circuit optoélectronique (12) fixé à un deuxième circuit électronique (14), le deuxième circuit électronique (14) comprenant des plots conducteurs électriquement (62), le premier circuit optoélectronique comprenant des pixels et comportant, pour chaque pixel :
une première couche conductrice électriquement (18) ;
au moins des premiers et deuxièmes éléments semiconducteurs tridimensionnels (20, 22) s'étendant perpendiculairement à la première couche conductrice électriquement et au contact de la première couche conductrice électriquement et ayant la même hauteur (H) mesurée perpendiculairement à la première couche conductrice électriquement ;
des premières zones actives (66) reposant sur les extrémités des premiers éléments semiconducteurs tridimensionnels opposées à la première couche conductrice électriquement et adaptées à émettre ou capter un premier rayonnement électromagnétique à une première longueur d'onde ;
des deuxièmes zones actives (66) reposant sur les extrémités des deuxièmes éléments semiconducteurs tridimensionnels opposées à la première couche conductrice électriquement et adaptées à émettre ou capter un deuxième rayonnement électromagnétique à une deuxième longueur d'onde différente de la première longueur d'onde ; et
des deuxième, troisième et quatrième couches conductrices électriquement (42, 44, 48) reliées électriquement aux plots (62) conducteurs électriquement, la deuxième couche conductrice électriquement étant reliée aux premières zones actives, la troisième couche conductrice électriquement (44) étant reliée aux deuxièmes zones actives et la quatrième couche conductrice électriquement (48) étant reliée à la première couche conductrice électriquement,
le procédé comprenant les étapes successives suivantes :
a) former le premier circuit optoélectronique (12) ; et
b) fixer le premier circuit optoélectronique à un deuxième circuit électronique (14) en reliant électriquement les deuxième, troisième et quatrième couches conductrices électriquement (42, 44, 48) aux plots conducteurs électriquement (62),
dans lequel l'étape a) comprend les étapes successives suivantes :
c) former simultanément sur un support (70) les premiers et deuxièmes éléments semiconducteurs tridimensionnels (20, 22) ;
d) former une couche isolante électriquement (32) entre les premiers éléments semiconducteurs tridimensionnels (20) et entre les deuxièmes éléments semiconducteurs tridimensionnels (22) ;
e) graver partiellement la couche isolante électriquement (32) et les premiers et deuxièmes éléments semiconducteurs tridimensionnels de sorte que les premiers et deuxièmes éléments semiconducteurs tridimensionnels aient la même hauteur (H) ;
f) former simultanément les premières zones actives (66) sur les extrémités des premiers éléments semiconducteurs tridimensionnels opposées au support et les deuxièmes zones actives (66) sur les extrémités des deuxièmes éléments semiconducteurs tridimensionnels opposées au support ; et
g) former les deuxième, troisième et quatrième couches conductrices électriquement (42, 44, 48),
le procédé comprenant entre les étapes a) et b) ou après l'étape b) les étapes successives suivantes :
h) retirer le support ; et
i) former la première couche conductrice électriquement (18) .

2. Procédé selon la revendication 1, comprenant, en outre, entre les étapes h) et i), l'étape de gravure de la couche isolante électriquement (32) et des premiers et deuxièmes éléments semiconducteurs tridimensionnels (20, 22) du côté opposé aux premières et deuxièmes zones actives (66).

3. Procédé selon la revendication 1 ou 2, dans lequel le diamètre (D1) de chaque premier élément semiconducteur au contact avec la première couche conductrice électriquement est inférieur au diamètre (D2) de chaque deuxième élément semiconducteur au contact avec la première couche conductrice électriquement.

4. Procédé selon l'une quelconque des revendications 1 à 3, dans lequel les premiers éléments semiconducteurs tridimensionnels sont régulièrement répartis selon un premier pas moyen et dans lequel les deuxièmes éléments semiconducteurs tridimensionnels sont régulièrement répartis selon un deuxième pas moyen différent du premier pas moyen.

5. Procédé selon l'une quelconque des revendications 1 à 4, dans lequel le premier circuit optoélectronique (12) comprend, en outre, pour chaque pixel :
au moins des troisièmes éléments semiconducteurs tridimensionnels (24) s'étendant perpendiculairement à la première couche conductrice électriquement (18) et au contact de la première couche conductrice électriquement, les premiers, deuxièmes et troisièmes éléments semiconducteurs tridimensionnels (20, 22, 24) ayant la même hauteur (H) mesurée perpendiculairement à la première couche conductrice électriquement ;
des troisièmes zones actives (66) reposant sur les extrémités des troisièmes éléments semiconducteurs tridimensionnels opposées à la première couche conductrice électriquement et adaptées à émettre ou capter un rayonnement électromagnétique à une troisième longueur d'onde différente des première et deuxième longueurs d'onde ; et
une cinquième couche conductrice électriquement (46) reliée électriquement à l'un des plots conducteurs électriquement (62) et reliée aux troisièmes zones actives.

6. Procédé selon la revendication 5, dans lequel le diamètre (D2) de chaque deuxième élément semiconducteur au contact avec la première couche conductrice électriquement est inférieur au diamètre (D3) de chaque troisième élément semiconducteur au contact avec la première couche conductrice électriquement.

7. Procédé selon la revendication 5 ou 6, dans lequel les troisièmes éléments semiconducteurs tridimensionnels sont régulièrement répartis selon un troisième pas moyen différent du premier pas moyen et du deuxième pas moyen.

8. Procédé selon l'une quelconque des revendications 1 à 7, dans lequel les premières et deuxièmes zones actives (66) comprennent un puits quantique unique ou des puits quantiques multiples.

9. Procédé selon l'une quelconque des revendications 1 à 8, dans lequel les premiers et deuxièmes éléments semiconducteurs tridimensionnels (20, 22) sont majoritairement en un matériau semiconducteur choisi dans le groupe comprenant les composés III-V, les composés II-VI ou les semiconducteurs ou composés du groupe IV.

10. Procédé selon l'une quelconque des revendications 1 à 9, dans lequel les premiers et deuxièmes éléments semiconducteurs tridimensionnels (20, 22) sont de forme filaire, conique ou tronconique.

11. Procédé selon l'une quelconque des revendications 1 à 10, dans lequel la dimension maximale de chaque pixel mesurée parallèlement à la première couche conductrice électriquement (18) est inférieure à 5 µm.

12. Procédé selon l'une quelconque des revendications 1 à 11, dans lequel les premiers et deuxièmes éléments semiconducteurs tridimensionnels (20, 22) sont de forme filaire, conique ou tronconique, dans lequel le diamètre (D1) de chaque premier élément semiconducteur au contact avec la première couche conductrice électriquement est inférieur au diamètre (D2) de chaque deuxième élément semiconducteur au contact avec la première couche conductrice électriquement, dans lequel les premières et deuxièmes zones actives (66) comprennent un puits quantique unique ou des puits quantiques multiples et dans lequel la longueur d'onde du rayonnement émis par les premières zones actives est supérieure à la longueur d'onde du rayonnement émis par les deuxièmes zones actives.

## Patentansprüche

1. Verfahren zum Herstellen einer optoelektronischen Vorrichtung (10), die eine erste optoelektronische Schaltung (12) umfasst, die mit einer zweiten elektronischen Schaltung (14) verbunden ist, wobei die zweite elektrische Schaltung (14) elektrisch leitende Felder (62) umfasst, wobei die erste optoelektronische Schaltung Pixel umfasst und für jedes Pixel umfasst:
eine erste elektrisch leitende Schicht (18);
zumindest erste und zweite dreidimensionale Halbleiterelemente (20, 22), die sich senkrecht zu der ersten elektrisch leitenden Schicht erstrecken und in Kontakt mit der ersten elektrisch leitenden Schicht stehen und die gleiche Höhe (H), gemessen senkrecht zu der ersten elektrisch leitenden Schicht, aufweisen;
erste aktive Bereiche (66), die auf den Enden der ersten dreidimensionalen Halbleiterelemente gegenüber der ersten elektrisch leitenden Schicht ruhen und in der Lage sind, eine erste elektromagnetische Strahlung bei einer ersten Wellenlänge auszusenden oder zu empfangen;
zweite aktive Bereiche (66), die auf den Enden der zweiten dreidimensionalen Halbleiterelemente gegenüber der ersten elektrisch leitenden Schicht ruhen und in der Lage sind, eine zweite elektromagnetische Strahlung bei einer zweiten Wellenlänge auszusenden oder zu empfangen, die von der ersten Wellenlänge unterschiedlich ist; und
zweite, dritte und vierte elektrisch leitende Schichten (42, 44, 48), die elektrisch mit den elektrisch leitenden Feldern (62) gekoppelt sind, wobei die zweite elektrisch leitende Schicht mit den ersten aktiven Bereichen gekoppelt ist, die dritte elektrisch leitende Schicht (44) mit den zweiten aktiven Bereichen gekoppelt ist und die vierte elektrisch leitende Schicht (48) mit der ersten elektrisch leitenden Schicht gekoppelt ist,
wobei das Verfahren die folgenden aufeinanderfolgenden Schritte umfasst:
a) Bilden der ersten optoelektronischen Schaltung (12); und
b) Verbinden der ersten optoelektronischen Schaltung mit einer zweiten elektronischen Schaltung (14) durch elektrisches Koppeln der zweiten, dritten und vierten elektrisch leitenden Schichten (42, 44, 48) mit den elektrisch leitenden Feldern (62),
wobei Schritt a) die folgenden Schritte umfasst:
c) gleichzeitiges Bilden der ersten und zweiten dreidimensionalen Halbleiterelemente (20, 22) auf einem Träger (70) ;
d) Bilden einer elektrisch isolierenden Schicht (32) zwischen den ersten dreidimensionalen Halbleiterelementen (20) und zwischen den zweiten dreidimensionalen Halbleiterelementen (22) ;
e) teilweises Ätzen der elektrisch isolierenden Schicht (32) und der ersten und zweiten dreidimensionalen Halbleiterelemente, so dass die ersten und zweiten dreidimensionalen Halbleiterelemente die gleiche Höhe (H) aufweisen;
f) gleichzeitiges Bilden der ersten aktiven Bereiche (66) an den Enden der ersten dreidimensionalen Halbleiterelemente gegenüber dem Träger und der zweiten aktiven Bereiche (66) an den Enden der zweiten dreidimensionalen Halbleiterelemente gegenüber dem Träger; und
g) Bilden der zweiten, dritten und vierten elektrisch leitenden Schichten (42, 44, 48),
wobei das Verfahren zwischen den Schritten a) und b) oder nach Schritt b) die folgenden aufeinanderfolgenden Schritte umfasst::
h) Entfernen des Trägers; und
i) Bilden der ersten elektrisch leitenden Schicht (18).

2. Verfahren nach Anspruch 1, das ferner zwischen den Schritten h) und i) den Schritt des Ätzens der elektrisch isolierenden Schicht (32) und der ersten und zweiten dreidimensionalen Halbleiterelemente (20, 22) auf der Seite gegenüber den ersten und zweiten aktiven Bereichen (66) umfasst.

3. Verfahren nach Anspruch 1 oder 2, wobei der Durchmesser (D1) von jedem ersten Halbleiterelement in Kontakt mit der ersten elektrisch leitenden Schicht kleiner ist als der Durchmesser (D2) von jedem zweiten Halbleiterelement in Kontakt mit der ersten elektrisch leitenden Schicht.

4. Verfahren nach irgendeinem der Ansprüche 1 bis 3, wobei die ersten dreidimensionalen Halbleiterelemente regelmäßig nach einem ersten mittleren Abstand verteilt sind und wobei die zweiten dreidimensionalen Halbleiterelemente regelmäßig nach einem zweiten mittleren Abstand verteilt sind, der sich von dem ersten mittleren Abstand unterscheidet.

5. Verfahren nach irgendeinem der Ansprüche 1 bis 4, wobei die erste optoelektronische Schaltung (12) ferner, für jedes Pixel, umfasst:
zumindest dritte dreidimensionale Halbleiterelemente (24), die sich senkrecht zu der ersten elektrisch leitenden Schicht (18) erstrecken und in Kontakt mit der ersten elektrisch leitenden Schicht stehen, wobei die ersten, zweiten und dritten dreidimensionalen Halbleiterelemente (20, 22, 24) die gleiche Höhe (H) senkrecht zu der ersten elektrisch leitenden Schicht gemessen aufweisen;
dritte aktive Bereiche (66), die auf den Enden der dritten dreidimensionalen Halbleiterelemente gegenüber der ersten elektrisch leitenden Schicht ruhen und in der Lage sind, eine elektromagnetische Strahlung bei einer dritten Wellenlänge, die sich von den ersten und zweiten Wellenlängen unterscheidet, auszusenden oder zu empfangen; und
eine fünfte elektrisch leitende Schicht (46), die mit einem der elektrisch leitenden Felder (62) elektrisch gekoppelt ist und mit den dritten aktiven Bereichen gekoppelt ist.

6. Verfahren nach Anspruch 5, wobei der Durchmesser (D2) von jedem zweiten Halbleiterelement in Kontakt mit der ersten elektrisch leitenden Schicht kleiner ist als der Durchmesser (D3) von jedem dritten Halbleiterelement in Kontakt mit der ersten elektrisch leitenden Schicht.

7. Verfahren nach Anspruch 5 oder 6, wobei die dritten dreidimensionalen Halbleiterelemente regelmäßig nach einem dritten mittleren Abstand verteilt sind, der sich von dem ersten mittleren Abstand und dem zweiten mittleren Abstand unterscheidet.

8. Verfahren nach irgendeinem der Ansprüche 1 bis 7, wobei die ersten und zweiten aktiven Bereiche (66) einen einzelnen Quantenwall oder mehrere Quantenwälle umfassen.

9. Verfahren nach irgendeinem der Ansprüche 1 bis 8, wobei die ersten und zweiten dreidimensionalen Halbleiterelemente (20, 22) hauptsächlich aus einem Halbleitermaterial hergestellt sind, das aus der Gruppe ausgewählt ist, die III-V-Verbindungen, II-VI-Verbindungen oder Halbleiter oder Verbindungen der Gruppe IV umfasst.

10. Verfahren nach irgendeinem der Ansprüche 1 bis 9, wobei die ersten und zweiten dreidimensionalen Halbleiterelemente (20, 22) eine Draht-, Kegel- oder Kegelstumpfform aufweisen.

11. Verfahren nach irgendeinem der Ansprüche 1 bis 10, wobei die maximale Abmessung jedes Pixels, gemessen parallel zu der ersten elektrisch leitenden Schicht (18), kleiner als 5 µm ist.

12. Verfahren nach irgendeinem der Ansprüche 1 bis 11, wobei die ersten und zweiten dreidimensionalen Halbleiterelemente (20, 22) eine Draht-, Kegel- oder Kegelstumpfform aufweisen, wobei der Durchmesser (D1) von jedem ersten Halbleiterelement in Kontakt mit der ersten elektrisch leitenden Schicht kleiner ist als der Durchmesser (D2) von jedem zweiten Halbleiterelement in Kontakt mit der ersten elektrisch leitenden Schicht, wobei die ersten und zweiten aktiven Bereiche (66) einen einzelnen Quantenwall oder mehrere Quantenwälle umfassen und wobei die Wellenlänge der Strahlung, die durch die ersten aktiven Bereiche ausgesendet wird, größer ist als die Wellenlänge der Strahlung, die durch die zweiten aktiven Bereiche ausgesendet wird.

## Claims

1. A method of manufacturing an optoelectronic device (10) comprising a first optoelectronic circuit (12) bonded to a second electronic circuit (14), the second electric circuit (14) comprising electrically-conductive pads (62), the first optoelectronic circuit comprising pixels and comprising, for each pixel:
a first electrically-conductive layer (18);
at least first and second three-dimensional semiconductor elements (20, 22) extending perpendicularly to the first electrically-conductive layer and in contact with the first electrically-conductive layer and having the same height (H) measured perpendicularly to the first electrically-conductive layer;
first active areas (66) resting on the ends of the first three-dimensional semiconductor elements opposite to the first electrically-conductive layer and capable of emitting or of receiving a first electromagnetic radiation at a first wavelength;
second active areas (66) resting on the ends of the second three-dimensional semiconductor elements opposite to the first electrically-conductive layer and capable of emitting or of receiving a second electromagnetic radiation at a second wavelength different from the first wavelength; and
second, third, and fourth electrically-conductive layers (42, 44, 48) electrically coupled to the electrically-conductive pads (62), the second electrically-conductive layer being coupled to the first active areas, the third electrically-conductive layer (44) being coupled to the second active areas and the fourth electrically-conductive layer (48) being coupled to the first electrically-conductive layer,
the method comprising the successive steps of:
a) forming the first optoelectronic circuit (12); and
b) bonding the first optoelectronic circuit to a second electronic circuit (14) by electrically coupling the second, third, and fourth electrically-conductive layers (42, 44, 48) to the electrically-conductive pads (62),
wherein step a) comprises the steps of:
c) simultaneously forming on a support (70) the first and second three-dimensional semiconductor elements (20, 22);
d) forming an electrically-insulating layer (32) between the first three-dimensional semiconductor elements (20) and between the second three-dimensional semiconductor elements (22);
e) partially etching the electrically-insulating layer (32) and the first and second three-dimensional semiconductor elements so that the first and second three-dimensional semiconductor elements have the same height (H);
f) simultaneously forming the first active areas (66) on the ends of the first three-dimensional semiconductor elements opposite to the support and the second active areas (66) on the ends of the second three-dimensional semiconductor elements opposite to the support; and
g) forming the second, third, and fourth electrically-conductive layers (42, 44, 48),
the method comprising between steps a) and b) or after step b) the successive steps of:
h) removing the support; and
i) forming the first electrically-conductive layer (18) .

2. The method of claim 1, further comprising, between steps h) and i), the step of etching the electrically-insulating layer (32) and first and second three-dimensional semiconductor elements (20, 22) on the side opposite to the first and second active areas (66).

3. The method of claim 1 or 2, wherein the diameter (D1) of each first semiconductor element in contact with the first electrically-conductive layer is smaller than the diameter (D2) of each second semiconductor element in contact with the first electrically-conductive layer.

4. The method of any of claims 1 to 3, wherein the first three-dimensional semiconductor elements are regularly distributed according to a first mean pitch and wherein the second three-dimensional semiconductor elements are regularly distributed according to a second mean pitch different from the first mean pitch.

5. The method of any of claims 1 to 4, wherein the first optoelectronic circuit (12) further comprises, for each pixel:
at least third three-dimensional semiconductor elements (24) extending perpendicularly to the first electrically-conductive layer (18) and in contact with the first electrically-conductive layer, the first, second, and third three-dimensional semiconductor elements (20, 22, 24) having the same height (H) measured perpendicularly to the first electrically-conductive layer;
third active areas (66) resting on the ends of the third three-dimensional semiconductor elements opposite to the first electrically-conductive layer and capable of emitting or of receiving an electromagnetic radiation at a third wavelength different from the first and second wavelengths; and
a fifth electrically-conductive layer (46) electrically coupled to one of the electrically-conductive pads (62) and coupled to the third active areas.

6. The method of claim 5, wherein the diameter (D2) of each second semiconductor element in contact with the first electrically-conductive layer is smaller than the diameter (D3) of each third semiconductor element in contact with the first electrically-conductive layer.

7. The method of claim 5 or 6, wherein the third three-dimensional semiconductor elements are regularly distributed according to a third mean pitch different from the first mean pitch and from the second mean pitch.

8. The method of any of claims 1 to 7, wherein the first and second active areas (66) comprise a single quantum well or multiple quantum wells.

9. The method of any of claims 1 to 8, wherein the first and second three-dimensional semiconductor elements (20, 22) are mainly made of a semiconductor material selected from the group comprising III-V compounds, II-VI compounds, or group-IV semiconductors or compounds.

10. The method of any of claims 1 to 9, wherein the first and second three-dimensional semiconductor elements (20, 22) have a wire, conical, or frustoconical shape.

11. The method of any of claims 1 to 10, wherein the maximum dimension of each pixel measured parallel to the first electrically-conductive layer (18) is smaller than 5 µm.

12. The method of any of claims 1 to 11, wherein the first and second three-dimensional semiconductor elements (20, 22) have a wire, conical, or frustoconical shape, wherein the diameter (D1) of each first semiconductor element in contact with the first electrically-conductive layer is smaller than the diameter (D2) of each second semiconductor element in contact with the first electrically-conductive layer, wherein the first and second active areas (66) comprise a single quantum well or multiple quantum wells and wherein the wavelength of the radiation emitted by the first active areas is greater than the wavelength of the radiation emitted by the second active areas.
